Europäisches Patentamt

European Patent Office

Office européen des brevets

(19)

(11) **EP 1 533 624 A1**

(12) # EUROPEAN PATENT APPLICATION

(43) Date of publication:
**25.05.2005 Bulletin 2005/21**

(51) Int Cl.⁷: **G01R 31/28**

(21) Application number: **05100512.2**

(22) Date of filing: **27.01.2005**

| | |
|---|---|
| (84) Designated Contracting States:<br>**AT BE BG CH CY CZ DE DK EE ES FI FR GB GR**<br>**HU IE IS IT LI LT LU MC NL PL PT RO SE SI SK TR**<br>Designated Extension States:<br>**AL BA HR LV MK YU** | (72) Inventors:<br>• **Kursula, Mikko**<br>  **90100, Oulu (FI)**<br>• **Vartiovaara, Heikki**<br>  **90440, Kempele (FI)** |
| (30) Priority: **08.11.2004 FI 20045426** | (74) Representative: **Antila, Harri Jukka Tapani**<br>**Kolster Oy Ab,**<br>**P.O. Box 148,**<br>**Iso Roobertinkatu 23**<br>**00121 Helsinki (FI)** |
| (71) Applicant: **Elektrobit Oy**<br>**90570 Oulu (FI)** | |

(54) **Characterization of electric circuit of electric device**

(57)    A method of characterizing an electric circuit of an electric device, a system, an electric device and a test device are provided. The system includes: a signal generator for generating a test signal having a radio frequency band spanning at least a portion of a frequency response range of the electric circuit; a load modulator for modulating the load with the test signal, thus generating a response signal in the electric circuit; and a correlator for generating cross-correlation between the response signal and the test signal.

Fig. 1

EP 1 533 624 A1

## Description

### Field

The invention relates to a method of characterizing an electric circuit of an electric device, a system for characterizing an electric circuit of an electric device, an electric device, and a test device.

### Background

Characterization of electric circuits of electric devices is an important part of test procedures associated, for example, with production testing and fault diagnostics in a service situation.

In prior art characterization procedures, an electric circuit is subjected to functional testing, where the electric circuit is inputted a test signal that mimics a real signal occurring in the device. The functional response of the electric circuit to the test signal is recorded and compared with the response defined by the specifications, for example.

The functional testing, however, requires a complicated external measuring arrangements and wiring systems for accessing the appropriate connectors of the electric circuit. Therefore, it is useful to consider alternative solutions for characterizing electric circuits of electric devices.

### Brief description of the invention

An object of the invention is to provide an improved method, a system, an electric device and a testing device. According to a first aspect of the invention, there is provided a method of characterizing an electric circuit of an electric device, including: generating a test signal having a radio frequency band spanning at least a portion of a frequency response range of the electric circuit; modulating the load of the electric circuit with the test signal, thus generating a response signal in the electric circuit; and generating cross-correlation between the response signal and the test signal.

According to a second aspect of the invention, there is provided a system for characterizing an electric circuit of an electric device, the system including: a signal generator for generating a test signal having a radio frequency band spanning at least a portion of a frequency response range of the electric circuit; a load modulator for modulating the load of the electric circuit with the test signal, thus generating a response signal in the electric circuit; and a correlator for generating cross-correlation between the response signal and the test signal.

According to a third aspect of the invention, there is provided an electric device including: an electric circuit; a load modulator for modulating the load of the electric circuit with a test signal having a radio frequency band spanning at least a portion of the frequency response range of the electric ci rcuit, thus generating a response signal in the electric circuit; and a response signal output line for outputting the response signal in order to generate cross-correlation between the response signal and the test signal.

According to an another aspect of the invention, there is provided a test device for characterizing an electric circuit of an electric device the test device including: a signal generator for generating a test signal having a radio frequency band spanning at least a portion of a frequency response range of the electric circuit, a response signal being generated in the electric circuit when a load of the electric circuit is modulated with the test signal; and a correlator for generating cross-correlation between the response signal and the test signal.

The invention provides several advantages. The use of load modulation enables signal measurements to be made from either the output or input of an electric circuit, thus simplifying the access to the electric circuit. The cross-correlation between the test signal and the response signal is independent on signal components originating from the normal operation of the electric circuit, thus providing accuracy to the characterization of the electric circuit. Such signal components arise, for example, from the noise of the electric circuit.

### List of drawings

In the following, the invention will be described in greater detail with reference to embodiments and the accompanying drawings, in which

    Figure 1 shows an example of a system for characterizing an electric circuit;
    Figure 2 shows a signal chart, and
    Figure 3 shows an example of a methodology according to embodiments of the invention.

### Description of embodiments

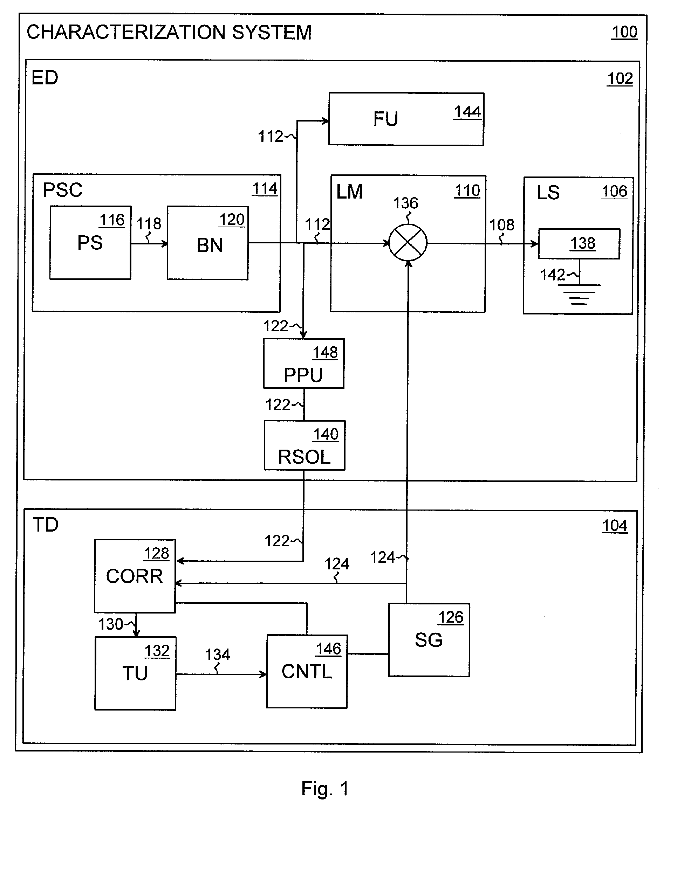

With reference to Figure 1, an example of a characterization system 100 is shown.

The characterization system 100 includes an electric device (ED) 102 and a test device (TD) 104 connected to the electric device 102.

The electric device 102 is an electrically operated apparatus, such as a cellular phone, a telecommunications system base station.

The test device 104 typically provides means for controlling a characterization procedure. The test device 104 may include a controller (CNTL) 146 for controlling functions of the characterization system 100. The test device 104 may be operated in the production line that produces electric devices 102.

The electric device 102 typically includes a power supply circuit (PSC) 114, a load circuit (LS) 106 and a load modulator (LM) 110. The load modulator 110 is connected to a power output of the power supply ci rcuit 114 and to a power input of the load circuit 106.

The power supply circuit 114 supplies electric power 108 to the load circuit 106 via the load modulator 110. Correspondingly, the load circuit 106 provides electric load, hereafter referred to as load, for the power supply circuit 114 via the load modulator 110.

In an embodiment of the invention, the power supply circuit 114 includes a power source 116 and a bypass network 120 connected to the power source 116. The power source 116 generates electric power 118 and feeds the electric power 118 to the bypass network 120.

The bypass network 120 passes the electric power 112 to the load modulator 110.

The bypass network 120 typically includes a network of electric circuits, such as rectifiers, capacitors, filters, and regulators. The bypass network 120 is characterized by an output impedance.

The power supply circuit 114 may be an accumulator and/or an amplifying circuit. In an embodiment of the invention, the power supply circuit 114 is a power amplifier of a cellular phone. In another embodiment of the invention, the power supply circuit 114 is a power amplifier of a telecommunications system base station.

In an embodiment of the invention, the load modulator 110 modulates an output load of the electric circuit with the test signal 124 obtained from a signal generator 126. In this case, the power supply circuit 114 represents an example of the electric circuit, and the output load is the load experienced by the power supply circuit 114. For the ease of discussion, the electric circuit is referred to with reference numeral 114 associated with the power supply circuit.

The load circuit 106 is typically an electric circuit having a lower potential than that of the output of the power supply circuit 114. In an embodiment of the invention, the load is provided by a resistor 138 connected to the ground 142. The present solution is not, however, restricted to a resistor, but any electric circuit providing suitable ohmic impedance may be used. In an embodiment of the invention, the load modulator 110 modulates an input load of the electric device with the test signal 124 obtained from a signal generator 126. In this case, the load circuit 106 represents an example of the electric circuit, and the input load is the load produced by the input impedance of the load circuit 106. For the ease of discussion, the electric circuit is referred to with the reference numeral 106 associated with the load circuit.

In an embodiment of the invention, the load circuit 106 is a terminal amplifier of a cellular phone.

In an embodiment of the invention, the load circuit 106 is a radio frequency component of a cellular phone.

In an embodiment of the invention, the load circuit 106 is a display of a cellular phone.

In an embodiment of the invention, the load circuit 106 is an A/V (audio visual) amplifier of a cellular phone.

In an embodiment of the invention, the load circuit 106 is A/V controller of a cellular phone.

The invention is not restricted, however, to the listed types of electric circuits, but may be applied to any electric circuit having response to a radio frequency test signal.

In an embodiment of the invention, the test signal 124 is an analogue signal.

In another embodiment of the invention, the test signal 124 is a digital signal where the frequency band is defined by the physical signal characteristics rather than the bit information. In load modulation, the input impedance of the load modulator 110 changes as a function of an instantaneous signal level of the test signal 124. Thereby, the electric circuit 106, 114 is subjected to a modulated load whose level depends on the signal level of the test signal 124.

In an embodiment of the invention, the load modulator 110 includes a multiplier 136 connected to the electric circuit 106, 114. The test signal 124 is inputted into the multiplier 136 multiplying an electric quantity, such as the current, associated with the electric power 112 by the instantaneous signal level of the test signal 124. As a result, the output load of the power supply circuit 114 and the input load of the load circuit 106 vary as a function of the signal level of the test signal 124.

The test signal 124 has a radio frequency band spanning at least a portion of the frequency response range of the electric circuit 106, 114.

In an embodiment of the invention, the frequency band is provided in the time domain. In such a case, the test signal 124 has at least one pulse whose temporal characteristics define the radio frequency band of the test signal 124.

The temporal characteristics of the pulse include, for example, the duration of the pulse, an interval between successive pulses, and the shape of the pulse. The temporal characteristics and other characteristics, such as power levels, of the test signal 124 may be obtained from the controller 146.

In an embodiment of the invention, the multiplier 136 includes a switch having two switch positions: a conductive position and a non-conductive position. In the conductive position, the load circuit 106 is connected to the power supply circuit 114. In the non-conductive position, the load circuit 106 is disconnected from the power supply circuit 114.

The switch position is controlled by the instantaneous signal level of the test signal 124. A threshold signal level may be determined, at which the switch position is changed from one to another.

The multiplier 136 may be implemented with, for example, a power amplifier or an antenna amplifier of the electric device 102. The invention is not, however, restricted to the use of these amplifiers, but any electric circuit having a multiplier capability may be used.

The frequency dependence of the output impedance of the bypass network 120 typically produces a response signal 122 generated in the power supply circuit 114 when the output load is modulated with the test signal 124.

The electric circuit 106, 114 is characterized by a frequency response range defining a frequency band that covers, for example, trace frequencies indicating a possible failure of the electric circuit 106, 114. Also, the frequency response range defines a frequency band covering candidate anomalous frequencies that may be disadvantageous from the point of view of the operation of the electric device 102. The frequency response range may range from 0 to 1.9 GHz, for example, thus corresponding to the frequency band used in the GSM (Global System for Mobile communications). The frequency range is not however, restricted to the given figures but may be defined by the characteristics of the electric circuit being tested.

The frequency response range of the power supply circuit 114 typically falls to a megahertz region ranging from a few megahertz to hundreds of megahertz. The present solution is not, however, restricted to the given figures, but the frequency response range may vary depending on the embodiment.

The characterization system 100 further includes a correlator 128 for generating cross-correlation between the response signal 122 and the test signal 124.

The correlator 128 is connected to the signal generator 126 which inputs the test signal 124 into the correlator 128. In the meantime, the test signal 124 is fed into the load modulator 110.

The correlator 128 may be connected to the power supply circuit 114, from which the response signal 122 is taken to the correlator 128.

In mathematical terms, the cross-correlation may be expressed as

$$R(t) \otimes T(t) = \int_{t_1}^{t_2} R(\tau)\overline{T}(t-\tau)d\tau \; , \tag{1}$$

where T(t) represents the test signal 124 as a function of time t, R(t) represents the response signal 122 as a function of time t, $\otimes$ is the cross correlation symbol, $\overline{T}$ is the complex conjugate of T, and $\tau$ is an integration variable varying from a lower integration limit $t_1$ to an upper integration limit $t_2$. It should be noted that in another interpretation, Equation (1) represents a convolution of functions $\overline{T}(t)$ and R(t), where $\overline{T}(t)$ is the complex conjugate of T(t).

The cross-correlation typically represents an impulse response of the electric circuit 106, 114, thus characterizing the output impedance of the electric circuit 106, 114 in the time domain.

The correlator 128 executes a cross-correlation calculation by using Equation (1), for example.

The response signal 122 may be taken from any point of the electric circuit 106, 114 provided that the point is sensitive to the load modulation.

In an embodiment of the invention, the response signal 122 is operationally connected to the output of the power supply circuit 114. In such a case, the response signal 122 is taken from the output of the power supply circuit 114.

In an embodiment of the invention, the response signal 122 is inputted into a preprocessing unit 148. The preprocessing unit 148 may include an analog-to-digital converter for converting the response signal 122 from an analogue format into a digital format. In this case, the response signal 128 is fed into the correlator 128 in the digital format, and the cross-correlation between the response signal 122 and the test signal 124 is calculated digitally.

The preprocessing unit 148 may further include analogue components, such as capacitors, resistors, and/or coils, and/or their combinations. The analogue components may provide a high-pass filter for blocking the direct current component from the response signal 122.

Some components of the preprocessing unit 148 may be located in the electric device 102 while some other components are located in the test device 104. In an embodiment of the invention, the analog components, such as those responsible for direct current blocking, may be located in the electric device 102. The analog-to-digital converter may be located in the test device 104.

In another embodiment of the invention, the preprocessing unit 148 is located in the electric device 102.

In another embodiment of the invention, the preprocessing unit 148 is located in the test device 104.

The power supply circuit 114 may simultaneously supply power to a functional unit 144 of the electric device 102. The functional unit 144 is typically an electric circuit that is connected to the output of the power supply circuit 114 and executes some functions of the electric device 102. In an embodiment of the invention, the frequency of the test signal 124 equals a multiple of the clock frequency of the digital logic of the electric device 102.

In an embodiment of the invention, the characterization system further includes a transformation unit (TU) 132 connected to the correlator 128. The transformation unit 132 receives a signal 130 carrying the cross-correlation and transforms the cross-correlation into the frequency domain.

In an embodiment of the invention, the transformation unit 132 Fourier transforms the cross-correlation into the frequency domain by using FFT (Fast Fourier transformation), for example. As a result, a frequency response of the electric circuit 106, 114 is obtained.

The results 134 of the transformation may be taken to the controller 146 for further processing associated with, for example, spectrum analysis and detection of defects of the power supply circuit 114.

The transformation unit 132 may be controlled by the controller 146.

The correlator 128, the signal generator 126, and the transformation unit 132 may each be located in the electric device 102 or in the test device 104.

In an embodiment of the invention, the signal generator 126 is included in the electric device 102. In such a case, the signal generator 126 may be implemented, for example, with a digitally controlled current source in an integrated circuit of the electric device 102.

In another embodiment, the signal generator 126 is included in the test device 104. In such a case, the signal generator 126 may be implemented with a commercial frequency synthesizer.

In an embodiment of the invention, the correlator 128 is included in the electric device 102. The correlator 128 may be implemented with a digital signal processor, memory, and software, for example. Applications may exist where the correlator 128 is implemented with an ASIC (Application Specific Integrated Circuit).

In another embodiment of the invention, the correlator 128 is included in the test device 104. In such a case, the electric device 102 may i n-clude a response signal output line 140 for outputting the response signal 122 in order to generate the cross-correlation between the response signal 122 and the test signal 124. The correlator 128 is in this case connectable to the response signal output line 140 when an electric circuit characterization procedure is required.

If the correlator 128 is located in the electric device 102, the output line 140 may be a connector or a switch between the power supply circuit 114 and the correlator 128.

The correlator 128 may be located in the electric device 102 or in the test device 104 depending on the embodiment.

The response signal output line 140 may be an analogue or a digital bus, for example. The correlator 128 may be implemented with a digital signal processor, memory, and software of the test device 104.

In an embodiment of the invention, the transformation unit 132 is included in the electric device 102. The transformation unit 132 may be implemented with a digital signal processor, memory, and software, for example. Applications may exist where the transformation unit 132 is implemented with an ASIC (Application Specific Integrated Circuit).

In another embodiment of the invention, the transformation unit is included in the test device 104. The transformation unit 132 may be implemented with the digital signal processor, memory, and software of the test device 104. Applications may exist where the transformation unit 132 is implemented with an ASIC (Application Specific Integrated Circuit) located in the test device 104.

The controller 146 may be implemented with software executed in a computer of the test device 104. The test device 104 may be based on a PC (Personal Computer) platform providing a user interface and processing power.

The PC may be supplemented with interface means, such as digital and analogue buses, that connect the test device 104 to the electric device 102.

The test device 104 may further include test structures, such as those compliant with IEEE1149.X (X=1, 4) boundary scan standards. The test structures provide controllable signal paths for signals, such as the response signal 122 and the test signal 124 between the test device 104 and the electric device 102.

The electric device 102 may include internal test structures, such as those compliant with IEEE1149.X (X=1, 4) boundary scan standards. The internal test structure may provide means for switching the electric power 112 from the power supply circuit 114 to the load modulator 110 and means for switching the response signal 122 to the response signal output line 140 and/or to the correlator 128.

The structure, use, and implementation of standardized test structures are known to one skilled in the art when using the teachings disclosed.

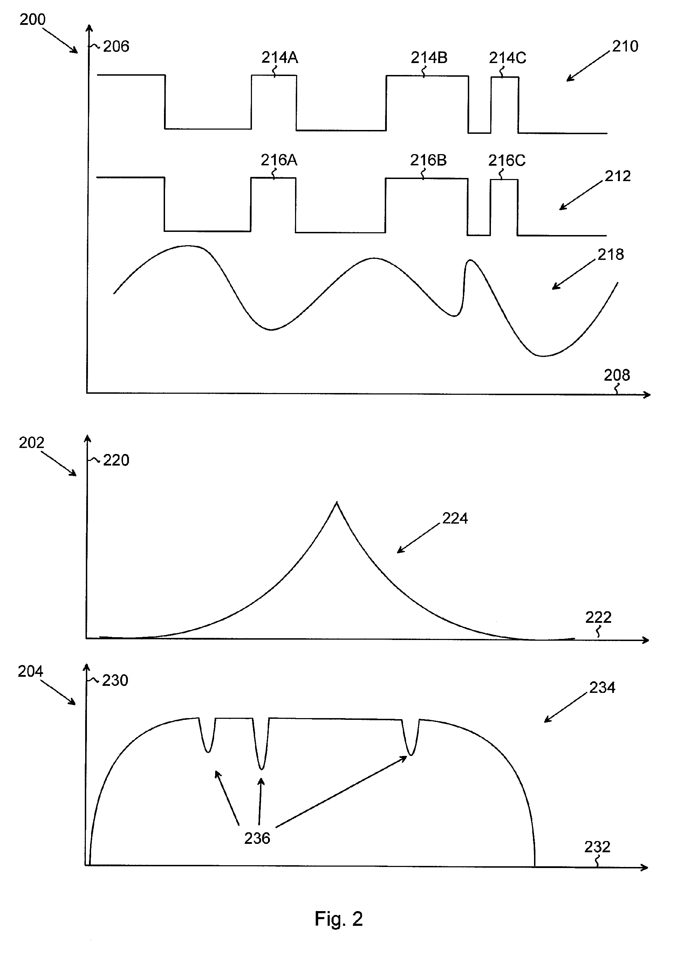

With reference to Figure 2, an example of a time domain representation 200 of the test signal 210, the modulated load 212, and the response signal 218 are shown. The vertical axis 206 and the horizontal axis 208 show signal level and time, respectively, in arbitrary units.

In an embodiment of the invention, the pulses 214A to 214C form a known digital pulse sequence, such as an MLS (Maximum Length Sequence). The use of a known pulse sequence simplifies the cross-correlation procedure, thus simplifying the structure of the correlator 128. Furthermore, the generation of the digital signal may be implemented with a simple digital signal generator 126.

The use of the MLS provides several advantages. The MLS may be designed so that it presents a plurality of test cases, thus enabling to characterize the electric circuit 106, 114 with a single pulse 214A to 214B. A typical duration of the pulse 214A to 214C is in the millisecond range, but the invention is not restricted to the given figure. The use of such a pulse 214A to 214B reduces the duration of the test signal 210 by a factor of 100 compared to prior art techniques, such as those applying a frequency scan.

The test signal 210 is typically a wideband signal whose radio frequency band spans at least a portion of the frequency response range of the electric circuit 114. In an embodiment of the invention, the radio frequency band of the test signal 210 spans the frequency response range of the electric circuit 114.

In an embodiment of the invention, the radio frequency band of the test signal 210 falls to the megahertz region ranging from a few megahertz to hundreds of megahertz. The present solution is not, however, restricted to the given figures, but the frequency response range may vary depending on the embodiment.

The modulated load 212 is typically proportional to the signal level of the pulses 214A to 214C, and thereby, the modulated load includes load pulses 216A to 216C. The pulses 216A to 216C represent the time instants when the load is connected to the power supply circuit 114. The time gaps between the pulses 216A to 216C represent time instants when the load is disconnected from the electric circuit 106, 114.

The response signal 218 generated in the electric circuit 106, 114 is an analogue signal that primarily depends on the pulse structure of the test signal 210 and the frequency response characteristics of the power supply circuit 114.

Furthermore, Figure 2 shows an example of the cross-correlation curve 224 representing cross-correlation between the test signal 210 and the response signal 218 in the time domain 202. The vertical axis 220 and the horizontal axis 222 show cross-correlation level and time, respectively, in arbitrary units.

Furthermore, Figure 2 shows cross-correlation 234, herein referred to as a frequency response curve 234, in a frequency domain 204. The frequency response curve 234 may be obtained from the cross-correlation curve 224 with the FFT, for example. The vertical axis 230 and the horizontal axis 232 show cross-correlation level and frequency, respectively, in arbitrary units.

The frequency response curve 234 may include trace frequencies 236 that indicate a fault in the electric circuit 106, 114. The amplitude of the trace frequencies 236 may be detected in the controller 146, and a test report may be generated on the basis of the amplitude.

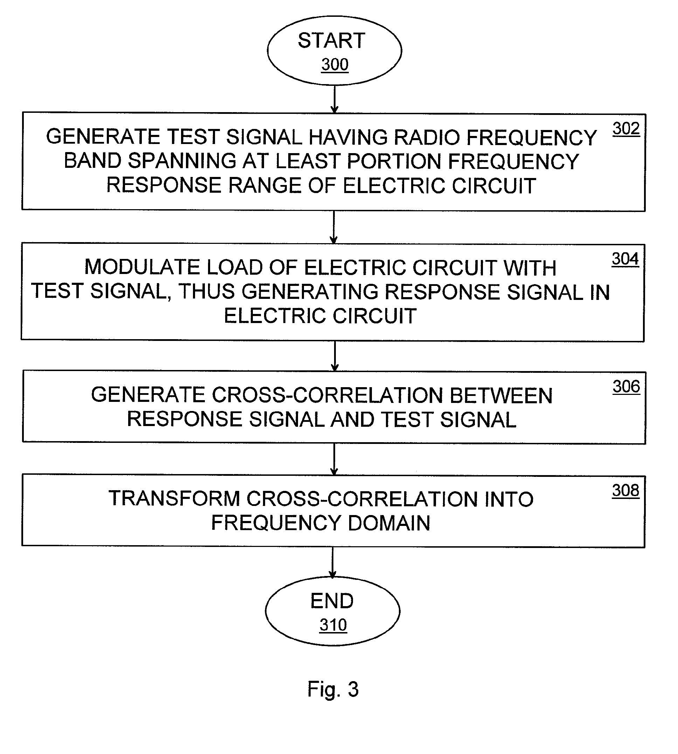

With reference to Figure 3, a methodology according to embodiments of the invention is shown in a flow chart.

In 300, the method starts.

In 302, a test signal 124 having a radio frequency band spanning at least a portion of a frequency response range of the electric circuit 106, 114 is generated.

In 304, the load of the electric circuit 106, 114 is modulated with the test signal 124, thus generating a response signal 122 in the electric circuit 106,114.

In an embodiment of the invention, the test signal 124 having at least one pulse 214A to 214C whose temporal characteristics define the radio frequency band is generated, and the load is modulated with the at least one pulse.

In 306, cross-correlation between the response signal 122 and the test signal 124 is generated.

In 308, according to an embodiment of the invention, the cross-correlation is transformed into a frequency domain 204.

In 310, the method ends.

The embodiments of the invention provide a plurality of advantages.

The use of the digital test signal 210 enables a simple implementation of the signal generator 126 to be used. Furthermore, the drop in the signal level of the test signal 124 in the feeding lines between the signal generator 126 and the load modulator 110 does not play a crucial role in load modulation when the digital signal is used. Furthermore, due to the digital test signal 124, a simple and robust switch structure may be applied in the load modulator 110. As regards the radio frequency band of the test signal 124, the use of the wideband test signal 124 enables the entire frequency response of the electric circuit 114 to be determined at once, thus resulting in a fast throughput of the test procedure.

The cross-correlation is insensitive to signal components originating from the normal operation of the electric circuit 106, 114. Such signal components arise, for example, from the noise of the electric circuit 106, 114 and from the effect of the functional units 144 of the electric device 102. As a result, in some embodiments, the electric device 102 may be operational while the electric circuit 106, 114 is characterized.

Even though the invention is disclosed above with reference to an example according to the accompanying drawings, it is clear that the invention is not restricted thereto but can be modified in several ways within the scope of the appended claims.

**Claims**

1. A method of characterizing an electric circuit of an electric device, **characterized by**
   generating (302) a test signal having a radio frequency band spanning at least a portion of a frequency response range of the electric circuit;
   modulating (304) the load of the electric circuit with the test signal, thus generating a response signal in the electric circuit; and
   generating (306) cross-correlation between the response signal and the test signal.

2. The method of claim 1, **characterized by** modulating (304) the input load of the electric circuit.

3. The method of claim 1, **characterized by** modulating (304) the output load of the electric circuit.

4. The method of claim 1, **characterized by**
   generating (302) the test signal having at least one pulse whose temporal characteristics define the radio frequency band; and
   modulating (304) the load with the at least one pulse.

5. The method of claim 1, **characterized by** transforming (308) the cross-correlation into a frequency domain.

6. A system for characterizing an electric circuit of an electric device, **characterized in that** the system includes:

   a signal generator (126) for generating a test signal having a radio frequency band spanning at least a portion of a frequency response range of the electric circuit;
   a load modulator (110) for modulating the load of the electric circuit with the test signal, thus generating a response signal in the electric circuit; and
   a correlator (128) for generating cross-correlation between the response signal and the test signal.

7. The system of claim 6, **characterized in that** load modulator is configured to modulate an input load of the electric circuit.

8. The system of claim 6, **characterized in that** load modulator is configured to modulate an output load of the electric circuit.

9. The system of claim 6, **characterized in that** the signal generator (126) is configured to generate the test signal having at least one pulse whose temporal characteristics define the radio frequency band; and the load modulator (110) is configured to modulate the load with the at least one pulse.

10. The system of claim 6, **characterized in that** the system further includes a transformation unit (132) for transforming the cross-correlation into a frequency domain.

11. An electric device including: an electric circuit (106, 114), **characterized in that** the electric device further includes:

    a load modulator (110) for modulating the load of the electric circuit (106,114) with a test signal having a radio frequency band spanning at least a portion of the frequency response range of the electric circuit (106, 114), thus generating a response signal in the electric circuit (106, 114); and
    a response signal output line (140) for outputting the response signal in order to generate cross-correlation between the response signal and the test signal.

12. The electric device of claim 11, **characterized in that** load modulator (110) is configured to modulate the input load of the electric circuit (106).

13. The electric device of claim 11, **characterized in that** load modulator (110) is configured to modulate the output load of the electric circuit (114).

**14.** The electric device of claim 11, **characterized in that** the electric device further includes a signal generator (126) for generating the test signal.

**15.** The electric device of claim 14, **characterized in that** the signal generator (126) is configured to generate the test signal having at least one pulse whose temporal characteristics define the radio frequency band; and
the load modulator (110) is configured to modulate the load with the at least one pulse.

**16.** The electric device of claim 11, **characterized in that** the electric device further includes a correlator (128) for generating the cross-correlation between the response signal and the test signal.

**17.** The electric device of claim 11, **characterized in that** the electric device further includes a transformation unit (132) for transforming the cross-correlation into a frequency domain.

**18.** A test device for characterizing an electric circuit of an electric device, **characterized in that** the test device includes:

a signal generator (126) for generating a test signal having a radio frequency band spanning at least a portion of a frequency response range of the electric circuit, a response signal being generated in the electric circuit when a load of the electric circuit is modulated with the test signal; and
a correlator (128) for generating cross-correlation between the response signal and the test signal.

**19.** The test device of claim 18, **characterized in that** the test signal modulates an input load of the electric circuit.

**20.** The test device of claim 18, **characterized in that** the test signal modulates an output load of the electric circuit.

**21.** The test device of claim 18, **characterized in that** the signal generator (126) is configured to generate the test signal having at least one pulse whose temporal characteristics define the radio frequency band.

**22.** The test device of claim 18, **characterized in that** the test device further includes a transformation unit (132) for transforming the cross-correlation into a frequency domain.

Fig. 1

Fig. 2

START
300

GENERATE TEST SIGNAL HAVING RADIO FREQUENCY    302
BAND SPANNING AT LEAST PORTION FREQUENCY
RESPONSE RANGE OF ELECTRIC CIRCUIT

MODULATE LOAD OF ELECTRIC CIRCUIT WITH    304
TEST SIGNAL, THUS GENERATING RESPONSE SIGNAL IN
ELECTRIC CIRCUIT

GENERATE CROSS-CORRELATION BETWEEN    306
RESPONSE SIGNAL AND TEST SIGNAL

TRANSFORM CROSS-CORRELATION INTO    308
FREQUENCY DOMAIN

END
310

Fig. 3

**European Patent Office**

## EUROPEAN SEARCH REPORT

Application Number

EP 05 10 0512

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2004/137870 A1 (KIVEKAS KALLE ET AL) 15 July 2004 (2004-07-15) * abstract * * paragraphs [0045], [0046], [0062]; figure 3 * ----- | 1-22 | G01R31/28 |
| A | US 6 236 371 B1 (BECK BRIAN C) 22 May 2001 (2001-05-22) * abstract; figures 3-5 * ----- | 1-22 | |

TECHNICAL FIELDS SEARCHED (Int.Cl.7)

G01R

The present search report has been drawn up for all claims

| Place of search | Date of completion of the search | Examiner |
|---|---|---|
| Berlin | 30 March 2005 | Binger, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 10 0512

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2005

| Patent document cited in search report | Publication date | Patent family member(s) | Publication date |
|---|---|---|---|
| US 2004137870 A1 | 15-07-2004 | WO 02084859 A1 | 24-10-2002 |
| US 6236371 B1 | 22-05-2001 | NONE | |

For more details about this annex : see Official Journal of the European Patent Office, No. 12/82